# EUROPEAN PATENT APPLICATION

(11) **EP 4 653 408 A1**
(43) Date of publication of application: **26.11.2025**
(21) Application number: 25170749.3
(22) Date of filing: 15.04.2025
(51) Int. Cl.: C04B 35/5831, C04B 41/00, C04B 41/52, C04B 41/89, C22C 26/00, C23C 14/02, C23C 14/06, C23C 14/32, C23C 28/04, B22F 3/14, B22F 3/24, B22F 5/00

(54) **CUBIC BORON NITRIDE SINTERED BODY AND TOOL HAVING COATED CUBIC BORON NITRIDE SINTERED BODY**

(30) Priority: 22.05.2024 JP 2024083271
(71) Applicant: Tungaloy Corporation, Iwaki-shi, Fukushima 970-1144 (JP)
(72) Inventor: SAKAMOTO, Takeru, Iwaki-shi Fukushima 970-1144 (JP)
(74) Representative: Vossius & Partner Patentanwälte Rechtsanwälte mbB

(57) **Abstract**

An object of the present invention is to provide a cubic boron nitride sintered body and a coated cubic boron nitride sintered body that can extend the tool life by having excellent wear resistance and fracture resistance. A cubic boron nitride sintered body including cubic boron nitride and a binder phase, wherein in a cross-sectional structure, content ratios of the cubic boron nitride and the binder phase fall within specific ranges, the binder phase includes a Ti compound phase containing a specific compound, an Al compound phase containing a specific compound, and a W compound phase containing WC, an average grain size of the W compound phase is 0.5 µm or more and 3.0 µm or less, content ratios of the Ti compound phase and the Al compound phase based on a whole of the binder phase fall within specific ranges, a content ratio X1 of the W compound phase is 2.0 area% or more and 30.0 area% or less, a content ratio X2 of the W compound phase based on a whole of the binder phase in a range from an interface between the cubic boron nitride and the binder phase to a distance of 300 nm toward the binder phase side is larger than the content ratio X1.

## Description

### BACKGROUND OF THE INVENTION

### FIELD OF THE INVENTION

The present invention relates to a cubic boron nitride sintered body and a tool having a coated cubic boron nitride sintered body.

### Description of Related Art

A cubic boron nitride sintered body includes cubic boron nitride (hereinafter also referred to as "cBN") and a binder phase. Conventionally, a cubic boron nitride sintered body containing a Ti compound as a material of the binder phase has been widely utilized for tools having a cBN sintered body for cutting of iron-based work materials such as steel or cast iron. This is because the cubic boron nitride sintered body containing a Ti compound has low affinity for the iron-based work material and is excellent in reaction wear resistance.

Hence, cBN sintered bodies containing various Ti compounds have been proposed in recent years. For example, Patent Publication JP-A-2020-28929 has proposed a cutting tool made of a cBN-based sintered body with at least a blade tip formed from a cBN-based sintered body containing cBN particles as a hard phase and containing Ti compound particles as a binder phase, wherein an average grain size of the Ti compound particles is 250 nm or less, a W-Co phase where a W component and a Co component coexist is present at interfaces of the Ti compound particles and an interface between the Ti compound particles and the cBN particles, and the W-Co phase is continuously present among the cBN particles and thereby constitutes a heat transfer path.

### Summary

### Technical Problem

However, conventional cubic boron nitride sintered bodies containing a Ti compound have low thermal conductivity and toughness and are thus susceptible to improvement. In recent years, higher efficiency is required in cutting, and high speed, high feeding speed, and deeper cutting depth are more remarkably required. Hence, recent cutting requires better fracture resistance and wear resistance of tools than ever before.

Under such circumstances, Patent Publication JP-A-2020-28929 discloses a cBN sintered body that has improved thermal conductivity and is excellent in wear resistance due to continuous presence of a W-Co phase among cBN particles. However, this invention is still susceptible to improvement in fracture resistance because no sufficient study has been made on a content ratio of the W-Co phase presumably present at a given proportion near the surface of cBN particles, and/or a grain size thereof.

An object of the present invention is to provide a cubic boron nitride sintered body and a coated cubic boron nitride sintered body that can extend the tool life by having excellent wear resistance and fracture resistance.

### Solution to Problem

The present inventor has conducted studies about the extension of the tool life and has accordingly found that fracture resistance can be improved by segregating a W compound phase containing WC near the surface of cBN particles in a cubic boron nitride sintered body containing a Ti compound, and controlling a grain size thereof, and as a result, the tool life can be extended. Finally, the present inventor has completed the present invention based on such findings.
[1] A cubic boron nitride sintered body comprising cubic boron nitride and a binder phase, wherein
   when a cross-sectional structure of the cubic boron nitride sintered body is observed, a content ratio of the cubic boron nitride is 10.0 area% or more and 60.0 area% or less, and a content ratio of the binder phase is 40.0 area% or more and 90.0 area% or less, based on 100 area% in total of the cubic boron nitride sintered body,
   the binder phase comprises a Ti compound phase, an Al compound phase, and a W compound phase,
   the Ti compound phase comprises a compound of Ti and at least one element selected from the group consisting of C, N, O, and B,
   the Al compound phase comprises a compound of Al and at least one element selected from the group consisting of C, N, O, and B,
   the W compound phase comprises WC,
   an average grain size of the W compound phase is 0.5 µm or more and 3.0 µm or less,
   in the cross-sectional structure, a content ratio of the Ti compound phase is 60.0 area% or more and 90.0 area% or less, a content ratio of the Al compound phase is more than 0.0 area% and 20.0 area% or less, and a content ratio X1 of the W compound phase is 2.0 area% or more and 30.0 area% or less, based on 100 area% in total of the binder phase, and
   in the cross-sectional structure, a content ratio X2 of the W compound phase based on 100 area% in total of the binder phase is larger than the content ratio X1 in a range from an interface between the cubic boron nitride and the binder phase to a distance of 300 nm toward the binder phase side.
[2] The cubic boron nitride sintered body according to [1], wherein
   the W compound phase further comprises at least one of a compound (except for WC) of W and at least one element selected from the group consisting of C, N, O, and B, and a compound of W and Co and at least one element selected from the group consisting of C, N, O, and B.
[3] The cubic boron nitride sintered body according to [1] or [2], wherein
   a ratio of the content ratio X2 to the content ratio X1 is 1.10 or more and 2.10 or less.
[4] The cubic boron nitride sintered body according to any one of [1] to [3], wherein
   the content ratio X2 is 3.0 area% or more and 45.0 area% or less.
[5] The cubic boron nitride sintered body according to any one of [1] to [4], wherein
   when an X-ray diffraction peak intensity on a (101) plane of WC in the binder phase is defined as I_{WC} and an X-ray diffraction peak intensity on a (004) plane of WB₂ is defined as I_{WB2}, a ratio of I_{WB2} to a total of I_{WC} and I_{WB2} is 0.00 or more and 0.03 or less.
[6] The cubic boron nitride sintered body according to any one of [1] to [5], wherein
   the W compound phase further comprises a compound of W and Co and at least one element selected from the group consisting of C, N, O, and B, and a content ratio (atomic ratio) of the Co element to a total content ratio of the W element and the Co element is 0.05 or more and 0.50 or less.
[7] A coated cubic boron nitride sintered body comprising the cubic boron nitride sintered body according to any one of [1] to [6] and a coating layer formed on a surface of the cubic boron nitride sintered body, wherein
   the coating layer is a single layer or a lamination of two or more layers, comprising at least one element selected from the group consisting of Ti, Zr, Hf, V, Nb, Ta, Cr, Mo, W, Al, and Si, and at least one element selected from the group consisting of C, N, O, and B, and
   an average thickness of a whole of the coating layer is 0.5 µm or more and 8.0 µm or less.
[8] A tool comprising the cubic boron nitride sintered body or the coated cubic boron nitride sintered body according to any one of [1] to [7].

### Advantageous Effects of Invention

The present invention can provide a cubic boron nitride sintered body and a coated cubic boron nitride sintered body that can extend the tool life by having excellent wear resistance and fracture resistance.

### Detailed Description

An embodiment for carrying out the present invention (hereinafter simply referred to as the "present embodiment") will hereinafter be described in detail. However, the present invention is not limited to the present embodiment described below. Various modifications may be made to the present invention without departing from the gist of the invention.

### [Cubic Boron Nitride Sintered Body]

A cBN sintered body of the present embodiment is a cBN sintered body including cBN and a binder phase, wherein when a cross-sectional structure of the cBN sintered body is observed, a content ratio of the cBN is 10.0 area% or more and 60.0 area% or less, and a content ratio of the binder phase is 40.0 area% or more and 90.0 area% or less, based on 100 area% in total of the cBN sintered body, the binder phase includes a Ti compound phase, an Al compound phase, and a W compound phase, the Ti compound phase contains a compound of Ti and at least one element selected from the group consisting of C, N, O, and B, the Al compound phase contains a compound of Al and at least one element selected from the group consisting of C, N, O, and B, the W compound phase contains WC, an average grain size of the W compound phase is 0.5 µm or more and 3.0 µm or less, in the cross-sectional structure, a content ratio of the Ti compound phase is 60.0 area% or more and 90.0 area% or less, a content ratio of the Al compound phase is more than 0.0 area% and 20.0 area% or less, and a content ratio X1 of the W compound phase is 2.0 area% or more and 30.0 area% or less, based on 100 area% in total of the binder phase, and in the cross-sectional structure, a content ratio X2 of the W compound phase based on 100 area% in total of the binder phase is larger than the content ratio X1 in a range from an interface between the cBN and the binder phase to a distance of 300 nm toward the binder phase side.

The cBN sintered body of the present embodiment, can improve, owing to such constitution, wear resistance and fracture resistance and as a result, can extend the tool life.

The detailed reason why the cBN sintered body of the present embodiment improves wear resistance and fracture resistance to provide an extended tool life is not clear, but the present inventor surmises the reason as follows. However, the reason is not limited thereto.

Since the content ratio of the cBN in the cBN sintered body of the present embodiment is 10.0 area% or more based on 100.0 area% in total of the cBN sintered body, the content ratio of the cBN excellent in mechanical strength is increased, and hence, mainly the fracture resistance is excellent. On the other hand, since the content ratio of the cBN in the cBN sintered body of the present embodiment is 60.0 area% or less, the content ratio of the cBN inferior in resistance to reaction with iron is decreased and hence, mainly the wear resistance is excellent. Since the content ratio of the binder phase in the cBN sintered body of the present embodiment is 40.0 area% or more, the content ratio of the cBN inferior in resistance to reaction with iron is relatively decreased, and hence, mainly the wear resistance is excellent. On the other hand, since the content ratio of the binder phase in the cBN sintered body of the present embodiment is 90.0 area% or less, the content ratio of the cBN excellent in mechanical strength is relatively increased, and hence, mainly the fracture resistance is excellent. Since the Ti compound phase in the cBN sintered body of the present embodiment contains a compound of Ti and at least one element selected from the group consisting of C, N, O, and B and the content ratio of the Ti compound phase is 60.0 area% or more based on 100.0 area% in total of the binder phase, the resistance to reaction with iron is improved, and hence, mainly the wear resistance is excellent. On the other hand, since the content ratio of the Ti compound phase in the cBN sintered body of the present embodiment is 90.0 area% or less, the thermal conductivity is improved, and hence, mainly the wear resistance is excellent. Since the Al compound phase in the cBN sintered body of the present embodiment contains a compound of Al and at least one element selected from the group consisting of C, N, O, and B and the content ratio of the Al compound phase is more than 0.0 area% based on 100.0 area% in total of the binder phase, the sinterability is improved, and hence, mainly the fracture resistance is excellent. On the other hand, since the content ratio of the Al compound phase in the cBN sintered body of the present embodiment is 20.0 area% or less, the content ratio of Al₂O₃ inferior in thermal conductivity and/or the content ratio of AIN inferior in mechanical strength is decreased, and hence, the wear resistance and/or the fracture resistance of the cBN sintered body is excellent. Since the W compound phase in the cBN sintered body of the present embodiment contains WC and the content ratio X1 of the W compound phase is 2.0 area% or more based on 100.0 area% in total of the binder phase, the thermal conductivity of the cBN sintered body is improved, and hence, mainly the wear resistance is excellent. On the other hand, since the content ratio X1 of the W compound phase is 30.0 area% or less, the hardness of the cBN sintered body is improved, and hence, mainly the wear resistance is excellent. Since the content ratio X2 of the W compound phase based on 100 area% in the binder phase in the cBN sintered body of the present embodiment is larger than the content ratio X1 in a range from an interface between the cBN and the binder phase to a distance of 300 nm toward the binder phase side, the content ratio of WC with small difference in thermal expansion coefficient from the cBN is higher than that in the Ti compound phase and the Al compound phase near the surface of the cBN particles so that strain ascribable to heat stress or stress concentration is reduced near the interface between the cBN and the binder phase, and hence, mainly the fracture resistance is improved. Since the average grain size of the W compound phase in the cBN sintered body of the present embodiment is 0.5 µm or more, the toughness of the cBN sintered body is improved, and hence, mainly the wear resistance is excellent. Furthermore, the effects brought about by the content ratio X2 higher than the content ratio X1 can be exerted effectively and reliably. On the other hand, since the average grain size of the W compound phase is 3.0 µm or less, the hardness of the cBN sintered body is improved, and hence, mainly the wear resistance is excellent.

The cBN sintered body of the present embodiment includes cBN and a binder phase. The content ratio of the cBN is 10.0 area% or more and 60.0 area% or less, and the content ratio of the binder phase is 40.0 area% or more and 90.0 area% or less. In the cBN sintered body of the present embodiment, the total content ratio of the cBN and the binder phase is 100.0 area%.

In the cBN sintered body of the present embodiment, the content ratios (area%) of the cBN and the binder phase can be determined by photographing an arbitrary cross-section with a scanning electron microscope (SEM) and analyzing the obtained SEM photograph using commercially available image analysis software. Specifically, the content ratios can be determined by a method disclosed in the Examples described below.

### [Cubic Boron Nitride (cBN)]

Since the content ratio of the cBN in the cBN sintered body of the present embodiment is 10.0 area% or more based on 100.0 area% in total of the cBN sintered body, the content ratio of the cBN excellent in mechanical strength is increased, and hence, mainly the fracture resistance is excellent. On the other hand, since the content ratio of the cBN is 60.0 area% or less, the content ratio of the cBN inferior in resistance to reaction with iron is decreased, and hence, mainly the wear resistance is excellent. From a similar point of view, the content ratio of the cBN is preferably 15.0 area% or more and 50.0 area% or less, and more preferably 20.0 area% or more and 40.0 area% or less.

### [Binder Phase]

Since the content ratio of the binder phase in the cBN sintered body of the present embodiment is 40.0 area% or more based on 100.0 area% in total of the cBN sintered body, the content ratio of the cBN inferior in resistance to reaction with iron is relatively decreased, and hence, mainly the wear resistance is excellent. On the other hand, since the content ratio of the binder phase is 90.0 area% or less, the content ratio of the cBN excellent in mechanical strength is relatively increased, and hence, mainly the fracture resistance is excellent. From a similar point of view, the content ratio of the binder phase is preferably 50.0 area% or more and 85.0 area% or less, and more preferably 60.0 area% or more and 80.0 area% or less.

In the cBN sintered body of the present embodiment, the binder phase includes a Ti compound phase, an Al compound phase, and a W compound phase.

The content ratio of the Ti compound phase is 60.0 area% or more and 90.0 area% or less based on 100.0 area% in total of the binder phase. Since the content ratio of the Ti compound phase is 60.0 area% or more, the resistance to reaction with iron is improved, and hence, mainly the wear resistance is excellent. On the other hand, since the content ratio of the Ti compound phase is 90.0 area% or less, the thermal conductivity is improved, and hence, mainly the wear resistance is excellent. From a similar point of view, the content ratio of the Ti compound phase is preferably 62.9 area% or more and 87.9 area% or less, and more preferably 67.1 area% or more and 82.4 area% or less.

In the cBN sintered body of the present embodiment, the Ti compound phase preferably contains at least one selected from the group consisting of TiC, TiCN, TiN, and TiB₂. Since the Ti compound phase contains such a compound, the reaction wear resistance tends to be excellent. From a similar point of view, the Ti compound phase more preferably contains at least one selected from the group consisting of TiC, TiCN, and TiB₂, further preferably contains TiC or TiB₂, and still further preferably contains TiC and TiB₂.

The content ratio of the Al compound phase is more than 0.0 area% and 20.0 area% or less based on 100.0 area% in total of the binder phase. Since the content ratio of the Al compound phase is more than 0.0 area%, the sinterability is improved, and hence, mainly the fracture resistance is excellent. On the other hand, since the content ratio of the Al compound phase is 20.0 area% or less, the content ratio of Al₂O₃ inferior in thermal conductivity and/or the content ratio of AIN inferior in mechanical strength is decreased, and hence, the wear resistance and/or the fracture resistance of the cBN sintered body is excellent. From a similar point of view, the content ratio of the Al compound phase is preferably 2.2 area% or more and 16.0 area% or less, and more preferably 3.0 area% or more and 12.9 area% or less.

In the cBN sintered body of the present embodiment, the Al compound phase preferably contains at least one selected from the group consisting of Al₂O₃, AIN, and AlB₂. Since the Al compound phase contains such a compound, the sinterability of the cBN sintered body is improved, and hence, the fracture resistance tends to be excellent. From a similar point of view, the Al compound phase more preferably contains at least one selected from the group consisting of Al₂O₃ and AIN, and further preferably contains Al₂O₃.

The content ratio X1 of the W compound phase is 2.0 area% or more and 30.0 area% or less based on 100.0 area% in total of the binder phase. Since the content ratio X1 of the W compound phase is 2.0 area% or more, the thermal conductivity of the cBN sintered body is improved, and hence, mainly the wear resistance is excellent. On the other hand, since the content ratio X1 of the W compound phase is 30.0 area% or less, the hardness of the cBN sintered body is improved, and hence, mainly the wear resistance is excellent. From a similar point of view, the content ratio of the W compound phase is preferably 2.2 area% or more and 27.7 area% or less, more preferably 5.0 area% or more and 26.0 area% or less, and still further preferably 6.1 area% or more and 22.0 area% or less.

In the cBN sintered body of the present embodiment, the W compound phase contains WC and preferably further contains at least one of a compound (except for WC) of W and at least one element selected from the group consisting of C, N, O, and B, and a compound of W and Co and at least one element selected from the group consisting of C, N, O, and B. The compound of W and at least one element selected from the group consisting of C, N, O, and B more preferably contains at least one selected from the group consisting of boride of W, carbide of W (except for WC), boride of W and Co, and carbide of W and Co, and still further preferably contains carbide of W (except for WC) and/or carbide of Wand Co. Here, examples of the compound contained in the W compound phase except for WC include Co₃W₃C, Co₆W₆C, W₂Co₂₁B₆, CoWB, W₂C, and WB, and a solid solution of Co in WC. Since the W compound phase contains such a compound, stress concentration is reduced near the interface between the cBN and the binder phase so that the binding force between the cBN and binder phase is improved, and hence, mainly the fracture resistance tends to be excellent. From a similar point of view, the W compound phase more preferably contains at least one selected from the group consisting of Co₃W₃C, and Co₆W₆C, and a solid solution of Co in WC, further preferably contains at least one selected from the group consisting of Co₃W₃C and a solid solution of Co in WC, and still further preferably consists of at least one selected from the group consisting of Co₃W₃C and a solid solution of Co in WC.

In the cBN sintered body of the present embodiment, the binder phase includes a Ti compound phase, an Al compound phase, and a W compound phase and preferably further contains a metal containing at least one element selected from the group consisting of W, Co, Ni, Al, Ti, V, Cr, Zr, Nb, Mo, Hf, and Ta, and/or a compound of at least one element selected from the group consisting of Co, Ni, Al, Ti, V, Cr, Zr, Nb, Mo, Hf, and Ta and at least one element selected from the group consisting of C, N, O, and B. Since the binder phase further contains such a component, the reaction sintering between the cubic boron nitride and the binder phase is accelerated, and hence, the cubic boron nitride sintered body excellent in wear resistance and fracture resistance tends to be obtained. Examples of the metal containing at least one element selected from the group consisting of W, Co, Ni, Al, Ti, V, Cr, Zr, Nb, Mo, Hf, and Ta, and the compound of at least one element selected from the group consisting of Co, Ni, Al, Ti, V, Cr, Zr, Nb, Mo, Hf, and Ta and at least one element selected from the group consisting of C, N, O, and B include VC, VN, Cr₃C₂, CrN, Cr₂N, ZrC, ZrN, ZrO₂, NbC, NbN, Mo₂C, HfC, HfC, TaC, TaN, Mo, Co, CoAl, and Ni. From a similar point of view as described above, the binder phase more preferably contains CrN, VC, NbN, or Mo₂C among them. In the case of containing such a compound, the content ratio thereof is preferably 0.1 area% or more and 10.0 area% or less, and more preferably 0.5 area% or more and 9.0 area% or less based on 100 area% in total of the binder phase.

In the cBN sintered body of the present embodiment, the content ratio X2 of the W compound phase based on 100 area% in total of the binder phase is preferably 3.0 area% or more and 45.0 area% or less in a range from an interface between the cBN and the binder phase to a distance of 300 nm toward the binder phase side. Since the content ratio X2 is 3.0 area% or more, the content ratio of WC with small difference in thermal expansion coefficient from the cBN is higher than that in the Ti compound and the Al compound near the cBN so that stress concentration is reduced near the interface between the cBN and the binder phase. The binding force between the cBN and the binder phase is improved, and hence, the fracture resistance tends to be further better. On the other hand, since the content ratio X2 is 45.0 area% or less, the proportion of the Ti compound phase and/or the Al compound phase near the cBN particles is relatively increased. The sinterability of the cBN sintered body is improved, and hence, the wear resistance and the fracture resistance tend to be further better. From a similar point of view, the content ratio X2 is more preferably 4.5 area% or more and 42.0 area% or less, and still further preferably 8.0 area% or more and 39.0 area% or less. The "total of the binder phase" in the definition of the content ratio X2 means the whole of the binder phase in a range from an interface between the cBN and the binder phase to a distance of 300 nm toward the binder phase side, and the "content ratio X2 of the W compound phase" means the content ratio of the W compound phase in a range from an interface between the cBN and the binder phase to a distance of 300 nm toward the binder phase side. If the region of the binder phase is narrow and a range from an interface between the cBN and the binder phase to a distance of 300 nm toward the binder phase side partially overlaps doubly with a range from another interface between the cBN and the binder phase to a distance of 300 nm toward the binder phase side, the area of the overlapping portion is not counted doubly. Likewise, if the ranges partially overlap triply or more, the area of the overlapping portion is not counted triply or more.

The ratio of the content ratio X2 to the content ratio X1 is preferably 1.10 or more and 2.10 or less. Since the ratio of the content ratio X2 to the content ratio X1 is 1.10 or more, the effects of reducing strain ascribable to heat stress or stress concentration near the interface between the cBN and the binder phase are exerted further effectively and reliably, and the fracture resistance tends to be improved. Since the ratio of the content ratio X2 to the content ratio X1 is 2.10 or less, the thermal conductivity in the binder phase is improved, and hence, the wear resistance tends to be excellent. From a similar point of view, the ratio of the content ratio X2 to the content ratio X1 is more preferably 1.20 or more and 2.01 or less, and still further preferably 1.30 or more and 1.90 or less.

When an X-ray diffraction peak intensity on a (101) plane of WC in the binder phase is defined as I_{WC} and an X-ray diffraction peak intensity on a (004) plane of WB₂ is defined as I_{WB2}, the ratio of I_{WB2} to the total of I_{WC} and I_{WB2} is preferably 0.00 or more and 0.03 or less. Since the ratio of I_{WB2} to the total of I_{WC} and I_{WB2}, I_{WB2}/(I_{WC} + I_{WB2}), is 0.00 or more and 0.03 or less, the W compound phase contains no WB₂ or, if the W compound phase contains WB₂, the value of the ratio is 0.03 or less, which indicates that the formation of boride of W with low mechanical strength is suppressed, and the toughness of the cBN sintered body is improved, and hence, the fracture resistance tends to be further better. From a similar point of view, the ratio I_{WB2}/(I_{WC} + I_{WB2}) is more preferably 0.00 or more and 0.02 or less, further preferably 0.00 or more and 0.01 or less, and still further preferably 0.00.

When the W compound phase further contains a compound of W and Co and at least one element selected from the group consisting of C, N, O, and B, the content ratio (atomic ratio) of the Co element to the total content ratio of the W element and the Co element is preferably 0.05 or more and 0.50 or less. Since the atomic ratio Co/(W + Co) in the W compound phase is 0.05 or more, the toughness of the W compound phase is improved so that the toughness of the cBN sintered body is improved, and hence, the fracture resistance tends to be further better. Since the atomic ratio Co/(W + Co) is 0.50 or less, the hardness of the W compound phase is improved so that the hardness of the cBN sintered body is improved, and hence, the wear resistance tends to be further better. From a similar point of view, the atomic ratio Co/(W + Co) is more preferably 0.10 or more and 0.43 or less, still further preferably 0.20 or more and 0.38 or less.

In the present embodiment, the composition of the cBN and each compound in the binder phase or the X-ray diffraction peak intensity can be identified using a commercially available X-ray diffractometer. For example, when an X-ray diffraction measurement is performed, using an X-ray diffractometer (product name "SmartLab") manufactured by Rigaku Corporation, by means of a 2θ/θ focusing optical system with Cu-Kα radiation under specific conditions, the composition of the binder phase can be identified. The measurement conditions are preferably conditions of, for example, output: 45 kV, 200 mA, incident-side Soller slit: 5°, divergence vertical slit: 2/3°, divergence vertical restriction slit: 5 mm, scattering slit: 2/3°, light-receiving side Soller slit: 5°, light reception slit: 0.3 mm, sampling width: 0.02°, scan speed: 1°/min, and 2θ measurement range: 30° to 90°.

In the present embodiment, the cBN sintered body may unavoidably contain impurities. Examples of the impurities include, but are not particularly limited to, lithium, calcium, silicon, and magnesium contained in raw material powders. Usually, the content ratio of the unavoidable impurities is 1 mass% or less based on the whole of the cBN sintered body. Thus, the unavoidable impurities rarely influence characteristic values of the cBN sintered body.

### [Method for Producing Cubic Boron Nitride Sintered Body]

The cBN sintered body of the present embodiment can be produced by, for example, the following method.

Cubic boron nitride (cBN) powder, TiC powder, TiCN powder, TiN powder, WC powder, Co powder, Al powder, CrN powder, VC powder, NbN powder, Mo₂C powder, and so on are prepared as raw material powders. Here, increasing the average particle size of the WC powder can result in an increased average grain size of the W compound to be obtained and a decreased value of the ratio I_{WB2}/(I_{WC} + I_{WB2}). The content ratios (area%) of the cBN and the binder phase in the cBN sintered body to be obtained can be controlled within the above specific ranges by appropriately adjusting the proportion of each raw material powder. The content ratio of the Co element to the total content ratio of the W element and the Co element (atomic ratio Co/(W + Co)) in the W compound phase can be controlled within the above specific range by appropriately adjusting the proportion of each raw material powder. Increasing the blending proportions of WC and Co tends to result in an increased value of the content ratio X2.

Here, these powders are surface-modified with an anionic polymer for the cBN powder and a cationic polymer for the WC powder and the Co powder (modification process). The surface-modified cBN powder, WC powder, and Co powder are stirred in ethanol for 1 to 24 hours so that the powders are statically adsorbed to each other, and further, centrifugation is performed for the removal of extra polymer (stirring process).

The content ratio X2 tends to become larger than the content ratio X1 by carrying out such a modification process and a stirring process. The ratio of the content ratio X2 to the content ratio X1 (X2/X1) tends to become large by carrying out the modification process and the stirring process and performing the stirring process for a longer treatment time. The ratio of the content ratio X2 to the content ratio X1 (X2/X1) tends to become large by carrying out the modification process and the stirring process using the WC powder having a smaller average grain size. Increasing the ratio (X2/X1) by such a method tends to result in an increased content ratio X2. Carrying out the method of increasing the content ratio X2 tends to increase the value of the ratio I_{WB2}/(I_{WC} + I_{WB2}).

Next, the individual raw material powders thus prepared are put in a ball mill cylinder together with alumina balls, hexane solvent, and paraffin, and then mixed. The content ratio (area%) of the Ti compound phase, the content ratio (area%) of the Al compound phase, and the content ratio X1 (area%) of the W compound phase in the binder phase can be controlled within the above specific ranges by appropriately adjusting the respective proportions of the raw material powder.

The raw material powders mixed in a ball mill are filled in a high-melting-point metal capsule made of Zr under the nitrogen atmosphere in a glovebox. A vacuum heat treatment is performed with the capsule left opened for removing moisture adsorbed onto the surface of the raw material powders filled and organic component. The capsule thus subjected to the vacuum heat treatment is sealed, and the raw material powders filled in the capsule are sintered at a high temperature and a high pressure. The conditions of the high-temperature sintering involve, for example, pressure: 4.0 to 7.0 GPa, temperature: 1200 to 1500°C, and sintering time: 20 to 60 minutes. Here, controlling the sintering temperature so as to be high tends to result in an increased value of the ratio I_{WB2}/(I_{WC} + I_{WB2}).

A method disclosed in Examples described below may be used as a more specific production method.

### [Coated Cubic Boron Nitride Sintered Body]

A coated cubic boron nitride sintered body of the present embodiment includes the aforementioned cubic boron nitride sintered body and a coating layer formed on a surface of the cubic boron nitride sintered body, wherein the coating layer is a single layer or a lamination of two or more layers, containing at least one element selected from the group consisting of Ti, Zr, Hf, V, Nb, Ta, Cr, Mo, W, Al, and Si and at least one element selected from the group consisting of C, N, O, and B, and an average thickness of a whole of the coating layer is 0.5 µm or more and 8.0 µm or less.

Since the coating layer is formed on the surface of the cubic boron nitride sintered body, the wear resistance of the cubic boron nitride sintered body is further improved. The coated cubic boron nitride sintered body of the present embodiment including the coating layer having the above components and constitution is excellent in wear resistance. Since the average thickness of the whole of the coating layer is 0.5 µm or more, mainly the wear resistance is improved. Since the average thickness is 8.0 µm or less, the fracture attributed to delamination is prevented, and hence, mainly the fracture resistance is excellent. From such a point of view, the average thickness of the whole of the coating layer is preferably 1.0 µm or more and 6.5 µm or less, and more preferably 1.5 µm or more and 6.0 µm or less.

Examples of the compound that forms the coating layer include TiCN, TiC, TiN, TiAlN, TiSiN, CrN, and NbN. The coating layer may have a structure where a plurality of layers differing in composition are alternately laminated. In this case, the average thickness per layer of each layer is, for example, 5 nm or more and 500 nm or less.

The thickness of each layer constituting the coating layer and the thickness of the whole of the coating layer can be measured from the cross-sectional structure of the coated cubic boron nitride sintered body with an optical microscope, SEM, a transmission electron microscope (TEM), or the like. The average thickness of each layer and the average thickness of the whole of the coating layer in the coated cubic boron nitride sintered body can be determined by measuring the thickness of each layer and the thickness of the whole of the coating layer from the cross-section at three or more locations near a position of 50 µm from a blade tip on a surface opposed to a metal evaporation source toward a central portion of the surface, and calculating average values thereof.

The composition of each layer constituting the coating layer can be measured from the cross-sectional structure of the coated cubic boron nitride sintered body with EDS, a wavelength dispersive X-ray analyzer (WDS), or the like.

Examples of the method for producing the coating layer in the coated cubic boron nitride sintered body of the present embodiment include, but are not particularly limited to, chemical deposition methods, and physical deposition methods such as ion plating, arc ion plating, sputtering, and ion mixing. Among them, arc ion plating is further preferable because of offering further better adhesion between the coating layer and cubic boron nitride sintered body.

### [Tool]

A tool of the present embodiment includes the aforementioned cubic boron nitride sintered body or the aforementioned coated cubic boron nitride sintered body. The tool of the present embodiment may have constitution similar to that of known tools except that the tool of the present embodiment includes the cubic boron nitride sintered body or the coated cubic boron nitride sintered body. Since the cubic boron nitride sintered body or the coated cubic boron nitride sintered body of the present embodiment is excellent in wear resistance and fracture resistance, the tool including it can be used as, for example, a cutting tool or a wear-resistant tool, and is preferably used as a cutting tool among them. The cubic boron nitride sintered body or the coated cubic boron nitride sintered body of the present embodiment is further preferably included in a cutting tool for carburized and hardened steel. The cubic boron nitride sintered body or the coated cubic boron nitride sintered body of the present embodiment, when included in a cutting tool or a wear-resistant tool, can extend the tool life compared to conventional ones.

### Examples

Although the present invention will be described in further detail below with the Examples, the present invention is not limited to such Examples.

### (Example 1)

### [Weighing of Raw Material Powder]

Cubic boron nitride (cBN) powder, TiC powder, TiCN powder, TiN powder, WC powder, Co powder, Al powder, CrN powder, VC powder, NbN powder, and Mo₂C powder were prepared, were weighed out to ratios shown in Table 1 and Table 2 below. Their average grain sizes were 2.0 µm (cBN powder), 2.0 µm (TiC powder), 2.0 µm (TiCN powder), 2.0 µm (TiN powder), 1.0 µm (Co powder), 0.5 µm (Al powder), 2.0 µm (Cr₂N powder), 2.0 µm (VC powder), 2.0 µm (NbN powder), and 2.0 µm (Mo₂C powder), and the average grain size of the WC powder was as shown in Table 3. The average grain sizes of the raw material powders were measured by the Fisher method (Fisher Sub-Sieve Sizer (FSSS)) disclosed in the B330 Standard of American Society for Testing and Materials (ASTM).

**[Table 1]**

| Sample No. | Blending Composition (Volume%) | | | | | | | | | | |
|---|---|---|---|---|---|---|---|---|---|---|---|
| | cBN | TiC | TiCN | TiN | WC | Co | Al | CrN | VC | NbN | Mo₂C |
| Invention Sample 1 | 30.0 | 57.0 | - | - | 5.7 | 1.3 | 6.0 | - | - | - | - |
| Invention Sample 2 | 58.0 | 34.0 | - | - | 2.1 | 0.5 | 5.4 | - | - | - | - |
| Invention Sample 3 | 50.0 | 41.0 | - | - | 3.2 | 0.8 | 5.0 | - | - | - | - |
| Invention Sample 4 | 40.0 | 49.0 | - | - | 4.9 | 1.1 | 5.0 | - | - | - | - |
| Invention Sample 5 | 20.0 | 65.0 | - | - | 8.0 | 2.0 | 5.0 | - | - | - | - |
| Invention Sample 6 | 15.0 | 70.0 | - | - | 8.3 | 1.9 | 4.8 | - | - | - | - |
| Invention Sample 7 | 10.0 | 74.0 | - | - | 8.8 | 2.0 | 5.2 | - | - | - | - |
| Invention Sample 8 | 30.0 | 61.5 | - | - | 2.8 | 0.7 | 5.0 | - | - | - | - |
| Invention Sample 9 | 30.0 | 50.5 | - | - | 12.0 | 2.7 | 4.8 | - | - | - | - |
| Invention Sample 10 | 30.0 | 47.0 | - | - | 13.7 | 4.5 | 4.8 | - | - | - | - |
| Invention Sample 11 | 30.0 | 44.0 | - | - | 17.1 | 3.9 | 5.0 | - | - | - | - |
| Invention Sample 12 | 30.0 | 50.5 | - | - | 4.5 | 1.0 | 14.0 | - | - | - | - |
| Invention Sample 13 | 30.0 | 50.5 | - | - | 6.8 | 1.6 | 11.1 | - | - | - | - |
| Invention Sample 14 | 30.0 | 50.5 | - | - | 14.7 | 3.3 | 1.5 | - | - | - | - |
| Invention Sample 15 | 30.0 | 48.5 | - | - | 15.9 | 3.5 | 2.1 | - | - | - | - |
| Invention Sample 16 | 30.0 | 52.5 | - | - | 12.5 | 2.9 | 2.1 | - | - | - | - |
| Invention Sample 17 | 30.0 | 56.5 | - | - | 9.2 | 2.1 | 2.2 | - | - | - | - |
| Invention Sample 18 | 30.0 | 54.5 | - | - | 3.5 | 0.8 | 11.2 | - | - | - | - |
| Invention Sample 19 | 30.0 | 57.5 | - | - | 1.2 | 0.3 | 11.0 | - | - | - | - |
| Invention Sample 20 | 30.0 | 50.5 | - | - | 10.2 | 2.3 | 7.0 | - | - | - | - |
| Invention Sample 21 | 30.0 | 50.5 | - | - | 10.2 | 2.3 | 7.0 | - | - | - | - |
| Invention Sample 22 | 30.0 | 50.5 | - | - | 10.2 | 2.3 | 7.0 | - | - | - | - |
| Invention Sample 23 | 30.0 | 50.5 | - | - | 10.2 | 2.3 | 7.0 | - | - | - | - |
| Invention Sample 24 | 30.0 | 57.5 | - | - | 5.7 | 1.3 | 5.5 | - | - | - | - |
| Invention Sample 25 | 30.0 | 57.5 | - | - | 5.7 | 1.3 | 5.5 | - | - | - | - |
| Invention Sample 26 | 30.0 | 57.5 | - | - | 5.7 | 1.3 | 5.5 | - | - | - | - |
| Invention Sample 27 | 30.0 | 57.5 | - | - | 5.7 | 1.3 | 5.5 | - | - | - | - |
| Invention Sample 28 | 30.0 | 57.5 | - | - | 4.6 | 2.4 | 5.5 | - | - | - | - |
| Invention Sample 29 | 30.0 | 57.5 | - | - | 5.0 | 2.0 | 5.5 | - | - | - | - |
| Invention Sample 30 | 30.0 | 57.5 | - | - | 6.2 | 0.8 | 5.5 | - | - | - | - |
| Invention Sample 31 | 30.0 | 57.5 | - | - | 6.6 | 0.4 | 5.5 | - | - | - | - |
| Invention Sample 32 | 30.0 | 57.5 | - | - | 6.8 | 0.2 | 5.5 | - | - | - | - |
| Invention Sample 33 | 30.0 | 57.5 | - | - | 7.0 | 0.0 | 5.5 | - | - | - | - |
| Invention Sample 34 | 30.0 | - | - | 57.5 | 5.7 | 1.3 | 5.5 | - | - | - | - |
| Invention Sample 35 | 30.0 | - | 57.5 | - | 5.7 | 1.3 | 5.5 | - | - | - | - |
| Invention Sample 36 | 30.0 | 50.5 | - | - | 5.7 | 1.3 | 5.5 | 7.0 | - | - | - |
| Invention Sample 37 | 30.0 | 50.5 | - | - | 5.7 | 1.3 | 5.5 | - | 7.0 | - | - |
| Invention Sample 38 | 30.0 | 50.5 | - | - | 5.7 | 1.3 | 5.5 | - | - | 7.0 | - |
| Invention Sample 39 | 30.0 | 50.5 | - | - | 5.7 | 1.3 | 5.5 | - | - | - | 7.0 |

**[Table 2]**

| Sample No. | Blending Composition (Volume%) | | | | | | | | | | |
|---|---|---|---|---|---|---|---|---|---|---|---|
| | cBN | TiC | TiCN | TiN | WC | Co | Al | CrN | VC | NbN | Mo₂C |
| Comparative Sample 1 | 70.0 | 24.5 | - | - | 0.5 | 0.1 | 4.9 | - | - | - | - |
| Comparative Sample 2 | 5.0 | 77.9 | - | - | 10.1 | 2.2 | 4.8 | - | - | - | - |
| Comparative Sample 3 | 30.0 | 65.1 | - | - | 2.3 | 0.5 | 2.1 | - | - | - | - |
| Comparative Sample 4 | 30.0 | 39.2 | - | - | 21.0 | 4.9 | 4.9 | - | - | - | - |
| Comparative Sample 5 | 30.0 | 50.4 | - | - | 2.3 | 0.5 | 16.8 | - | - | - | - |
| Comparative Sample 6 | 30.0 | 50.4 | - | - | 16.0 | 3.6 | 0.0 | - | - | - | - |
| Comparative Sample 7 | 30.0 | 45.5 | - | - | 18.2 | 4.2 | 2.1 | - | - | - | - |
| Comparative Sample 8 | 30.0 | 58.8 | - | - | 0.0 | 0.0 | 11.2 | - | - | - | - |
| Comparative Sample 9 | 30.0 | 50.5 | - | - | 10.2 | 2.3 | 7.0 | - | - | - | - |
| Comparative Sample 10 | 30.0 | 50.5 | - | - | 10.2 | 2.3 | 7.0 | - | - | - | - |
| Comparative Sample 11 | 30.0 | 57.5 | - | - | 5.7 | 1.3 | 5.5 | - | - | - | - |
| Comparative Sample 12 | 30.0 | 57.5 | - | - | 3.9 | 3.1 | 5.5 | - | - | - | - |

**[Table 3]**

| Sample No. | Average Grain Size of Raw Material Powder (µm) | Sample No. | Average Grain Size of Raw Material Powder (µm) |
|---|---|---|---|
| | WC | | WC |
| Invention Sample 1 | 1.5 | Comparative Sample 1 | 1.5 |
| Invention Sample 2 | 1.5 | Comparative Sample 2 | 1.5 |
| Invention Sample 3 | 1.5 | Comparative Sample 3 | 1.5 |
| Invention Sample 4 | 1.5 | Comparative Sample 4 | 1.5 |
| Invention Sample 5 | 1.5 | Comparative Sample 5 | 1.5 |
| Invention Sample 6 | 1.5 | Comparative Sample 6 | 1.5 |
| Invention Sample 7 | 1.5 | Comparative Sample 7 | 1.5 |
| Invention Sample 8 | 1.5 | Comparative Sample 8 | - |
| Invention Sample 9 | 1.5 | Comparative Sample 9 | 0.3 |
| Invention Sample 10 | 1.5 | Comparative Sample 10 | 4.0 |
| Invention Sample 11 | 1.5 | Comparative Sample 11 | 1.5 |
| Invention Sample 12 | 1.5 | Comparative Sample 12 | 1.5 |
| Invention Sample 13 | 1.5 | | |
| Invention Sample 14 | 1.5 | | |
| Invention Sample 15 | 1.5 | | |
| Invention Sample 16 | 1.5 | | |
| Invention Sample 17 | 1.5 | | |
| Invention Sample 18 | 1.5 | | |
| Invention Sample 19 | 1.5 | | |
| Invention Sample 20 | 0.5 | | |
| Invention Sample 21 | 1.0 | | |
| Invention Sample 22 | 2.0 | | |
| Invention Sample 23 | 3.0 | | |
| Invention Sample 24 | 1.5 | | |
| Invention Sample 25 | 1.5 | | |
| Invention Sample 26 | 1.5 | | |
| Invention Sample 27 | 1.5 | | |
| Invention Sample 28 | 1.5 | | |
| Invention Sample 29 | 1.5 | | |
| Invention Sample 30 | 1.5 | | |
| Invention Sample 31 | 1.5 | | |
| Invention Sample 32 | 1.5 | | |
| Invention Sample 33 | 1.5 | | |
| Invention Sample 34 | 1.5 | | |
| Invention Sample 35 | 1.5 | | |
| Invention Sample 36 | 1.5 | | |
| Invention Sample 37 | 1.5 | | |
| Invention Sample 38 | 1.5 | | |
| Invention Sample 39 | 1.5 | | |

### [Modification Process]

Of the weighed raw material powders, the individual raw material powders were surface modified with an anionic polymer sodium polystyrene sulfonate for the cBN powder and a cationic polymer poly(diallyl dimethyl ammonium chloride) for the WC powder and the Co powder. Table 4 shows the presence or absence of the modification process in each example.

### [Stirring Process]

Subsequently, the surface-modified cBN powder, WC powder, and Co powder were stirred in ethanol for 1 to 24 hours so that the powders were statically adsorbed to each other. Table 4 shows the processing time of the stirring process. The powders thus stirred were centrifuged for the removal of extra polymer. Neither the modification process nor the stirring process was carried out as to comparative sample 8 and comparative sample 11.

**[Table 4]**

| Sample No. | Modification Process | Stirring Process | Sample No. | Modification Process | Stirring Process |
|---|---|---|---|---|---|
| | Presence or absence of Process | Treatment Time (hr) | | Presence or absence of Process | Treatment Time (hr) |
| Invention Sample 1 | Present | 12 | Comparative Sample 1 | Present | 12 |
| Invention Sample 2 | Present | 12 | Comparative Sample 2 | Present | 12 |
| Invention Sample 3 | Present | 12 | Comparative Sample 3 | Present | 12 |
| Invention Sample 4 | Present | 12 | Comparative Sample 4 | Present | 12 |
| Invention Sample 5 | Present | 12 | Comparative Sample 5 | Present | 12 |
| Invention Sample 6 | Present | 12 | Comparative Sample 6 | Present | 12 |
| Invention Sample 7 | Present | 12 | Comparative Sample 7 | Present | 6 |
| Invention Sample 8 | Present | 12 | Comparative Sample 8 | Absent | Absent |
| Invention Sample 9 | Present | 12 | Comparative Sample 9 | Present | 18 |
| Invention Sample 10 | Present | 12 | Comparative Sample 10 | Present | 12 |
| Invention Sample 11 | Present | 8 | Comparative Sample 11 | Absent | Absent |
| Invention Sample 12 | Present | 12 | Comparative Sample 12 | Present | 12 |
| Invention Sample 13 | Present | 12 | | | |
| Invention Sample 14 | Present | 12 | | | |
| Invention Sample 15 | Present | 6 | | | |
| Invention Sample 16 | Present | 12 | | | |
| Invention Sample 17 | Present | 12 | | | |
| Invention Sample 18 | Present | 18 | | | |
| Invention Sample 19 | Present | 24 | | | |
| Invention Sample 20 | Present | 18 | | | |
| Invention Sample 21 | Present | 18 | | | |
| Invention Sample 22 | Present | 12 | | | |
| Invention Sample 23 | Present | 12 | | | |
| Invention Sample 24 | Present | 24 | | | |
| Invention Sample 25 | Present | 18 | | | |
| Invention Sample 26 | Present | 6 | | | |
| Invention Sample 27 | Present | 3 | | | |
| Invention Sample 28 | Present | 12 | | | |
| Invention Sample 29 | Present | 12 | | | |
| Invention Sample 30 | Present | 12 | | | |
| Invention Sample 31 | Present | 12 | | | |
| Invention Sample 32 | Present | 12 | | | |
| Invention Sample 33 | Present | 12 | | | |
| Invention Sample 34 | Present | 12 | | | |
| Invention Sample 35 | Present | 12 | | | |
| Invention Sample 36 | Present | 12 | | | |
| Invention Sample 37 | Present | 12 | | | |
| Invention Sample 38 | Present | 12 | | | |
| Invention Sample 39 | Present | 12 | | | |

### [Mixing Process]

The raw material powders after the stirring process and the remaining powders of the weighed raw material powders were put in a ball mill cylinder together with alumina balls, hexane solvent, and paraffin, and then mixed for 6 hours. Since neither the modification process nor the stirring process was carried out as to comparative sample 8 and comparative sample 11, the mixing process was performed using the weighed raw material powders instead.

### [Filling Process and Drying Process]

The mixed raw material powders were filled in a high-melting-point metal capsule made of Zr (hereinafter simply referred to as "capsule) under the nitrogen atmosphere in a glovebox. A vacuum heat treatment was performed with the capsule left opened for removing moisture adsorbed onto the surface of the filled raw material powders and organic component. The capsule thus subjected to the vacuum heat treatment was sealed.

### [Sintering Process]

The raw material powders filled in the capsule were sintered at a high temperature and a high pressure for 40 minutes. The conditions of the high-pressure sintering are shown in Table 5 below.

**[Table 5]**

| Sample No. | Sintering Process | | Sample No. | Sintering Process | |
|---|---|---|---|---|---|
| | Temperature (°C) | Pressure (GPa) | | Temperature (°C) | Pressure (GPa) |
| Invention Sample 1 | 1350 | 5.5 | Comparative Sample 1 | 1550 | 7.5 |
| Invention Sample 2 | 1500 | 7.0 | Comparative Sample 2 | 1150 | 3.5 |
| Invention Sample 3 | 1450 | 6.0 | Comparative Sample 3 | 1350 | 5.5 |
| Invention Sample 4 | 1400 | 5.5 | Comparative Sample 4 | 1350 | 5.5 |
| Invention Sample 5 | 1300 | 5.0 | Comparative Sample 5 | 1350 | 5.0 |
| Invention Sample 6 | 1250 | 4.5 | Comparative Sample 6 | 1350 | 6.0 |
| Invention Sample 7 | 1200 | 4.0 | Comparative Sample 7 | 1350 | 6.0 |
| Invention Sample 8 | 1350 | 5.5 | Comparative Sample 8 | 1350 | 5.0 |
| Invention Sample 9 | 1350 | 5.5 | Comparative Sample 9 | 1350 | 5.5 |
| Invention Sample 10 | 1350 | 5.5 | Comparative Sample 10 | 1350 | 5.5 |
| Invention Sample 11 | 1350 | 5.5 | Comparative Sample 11 | 1350 | 5.5 |
| Invention Sample 12 | 1350 | 5.0 | Comparative Sample 12 | 1350 | 5.5 |
| Invention Sample 13 | 1350 | 5.0 | | | |
| Invention Sample 14 | 1350 | 6.0 | | | |
| Invention Sample 15 | 1350 | 6.0 | | | |
| Invention Sample 16 | 1350 | 6.0 | | | |
| Invention Sample 17 | 1350 | 6.0 | | | |
| Invention Sample 18 | 1350 | 5.0 | | | |
| Invention Sample 19 | 1350 | 5.0 | | | |
| Invention Sample 20 | 1350 | 5.5 | | | |
| Invention Sample 21 | 1350 | 5.5 | | | |
| Invention Sample 22 | 1350 | 5.5 | | | |
| Invention Sample 23 | 1350 | 5.5 | | | |
| Invention Sample 24 | 1350 | 5.5 | | | |
| Invention Sample 25 | 1350 | 5.5 | | | |
| Invention Sample 26 | 1350 | 5.5 | | | |
| Invention Sample 27 | 1350 | 5.5 | | | |
| Invention Sample 28 | 1350 | 5.5 | | | |
| Invention Sample 29 | 1350 | 5.5 | | | |
| Invention Sample 30 | 1350 | 5.5 | | | |
| Invention Sample 31 | 1350 | 5.5 | | | |
| Invention Sample 32 | 1350 | 5.5 | | | |
| Invention Sample 33 | 1350 | 5.5 | | | |
| Invention Sample 34 | 1350 | 5.5 | | | |
| Invention Sample 35 | 1350 | 5.5 | | | |
| Invention Sample 36 | 1350 | 5.5 | | | |
| Invention Sample 37 | 1350 | 5.5 | | | |
| Invention Sample 38 | 1350 | 5.5 | | | |
| Invention Sample 39 | 1350 | 5.5 | | | |

### [Analysis with SEM Image]

In the cBN sintered body obtained by the high-pressure sintering, the content ratios (area%) of the cBN and the binder phase were determined by photographing the cross-sectional structure of the cBN sintered body with a scanning electron microscope (SEM) and analyzing the obtained photograph using commercially available image analysis software. More specifically, the cBN sintered body was polished to obtain a mirror-polished surface in a direction intersecting a surface thereof. Next, the mirror-polished surface of the cBN sintered body was enlarged at a magnification of 5000 times using a SEM and observed as a backscattered electron image. At this time, using an energy-dispersive X-ray spectroscope (EDS) included in the SEM, a black region was identified as cBN, and gray and white regions were identified as binder phases. In the binder phase, a dark gray region was identified as an Al compound phase, a light gray region was identified as a Ti compound phase, and a white region was identified as a W compound phase. Thereafter, structural photographs of the cross-section of the cBN were taken using the SEM. The structural photographs were taken so as to include 20 µm × 20 µm fields to obtain structural photographs of 20 fields in total. With image analysis software, the areas occupied by the cBN and the binder phase were determined from each of the structural photographs, and the content ratios (area%) were determined from the occupied areas. The content ratio (area%) of the Ti compound phase, the content ratio (area%) of the Al compound phase, and the content ratio X1 ( area%) of the W compound phase in the binder phase were also calculated from the content ratio of each phase based on the occupied area in the binder phase from structural photographs in the same manner as above. Each value was set to an average value of the values obtained from the structural photographs of 20 fields. When the binder phase contained materials other than the Al compound phase, the Ti compound phase, and the W compound phase, the materials were identified by combining analysis results of EDS mapping images, and the content ratios (area%) were calculated from their respective occupied areas determined.

Further, by analysis on structural photographs of the same fields as above, an area occupied by the binder phase and an area occupied by the W compound phase were each determined in a range from an interface between the cubic boron nitride and the binder phase to a distance of 300 nm toward the binder phase side, and the content ratio X2 (area%) of the W compound phase based on 100 area% in total of the binder phase was measured in the above range. The ratio of the X2 to the X1 was calculated from the obtained value.

Here, a mirror-polished surface of a cBN sintered body is a cross-section of a cBN sintered body obtained by mirror-polishing a surface or any cross-section of the cBN sintered body. A polishing method using diamond paste was used as a method for obtaining the mirror-polished surface of the cBN sintered body.

The results thus obtained are also shown in Table 6.

When the W compound phase contained a Co element, the content ratio (atomic ratio) of the Co element to the total content ratio of the W element and the Co element was calculated as follows: first, the same observation fields as those of structural photographs of the cBN sintered body photographed with SEM in the same manner as above were analyzed by EDS in the whole fields to measure the content ratios (atomic ratios) of the W element and the Co element contained in the cBN sintered body. The content ratio of the Co element to the total content ratio of the W element and the Co element (in the tables, referred to as Atomic ratio Co/(W + Co)) was calculated from the obtained values.

Through the image analysis of the structural photographs of the cubic boron nitride sintered body photographed with SEM, the area of a W compound grain in a cross-sectional structure was determined, and the diameter of a circle with an area equal to the thus obtained area was determined as the grain size of the W compound. An average value of the grain sizes of the W compound particles present in the structural photographs was determined as the average grain size of the W compound. These measurement results are shown in Table 7.

### [Analysis of Composition by X-Ray Diffraction (XRD)]

The composition of the binder phase included in the cBN sintered body obtained by the sintering process was analyzed by X-ray diffraction (XRD). The composition of the binder phase was identified using an X-ray diffractometer (product name "SmartLab") manufactured by Rigaku Corporation. Specifically, by means of a 2θ/θ focusing optical system with Cu-Kα radiation, the composition of the binder phase was identified by X-ray diffraction measurement under the following conditions.

### <X-Ray Diffractometry Conditions>

Output: 45 kV, 200 mA
Incident-side Soller slit: 5°
Divergence vertical slit: 2/3°
Divergence vertical restriction slit: 5 mm
Scattering slit: 2/3°
Light-receiving side Soller slit: 5°
Light reception slit: 0.3 mm
Sampling width: 0.02°
Scan speed: 1°/min
2θ measurement range: 30° to 90°

The analysis results are shown in Table 6. In Table 6, only phases that obtained a clear peak in the X-ray diffraction measurement were identified and are shown. Analysis using EDS was able to identify the presence of a W compound phase containing both of a W element and a Co element, except for invention sample 33 and comparative sample 8, and able to further identify Co₃W₃C contained in invention sample 28 and comparative sample 12. On the other hand, no clear peak of the phase containing both of the W element and the Co element was able to be identified as to samples other than invention sample 28, invention sample 33, comparative sample 8, and comparative sample 12. Therefore, such samples were presumed to contain Co₃W₃C or a solid solution of Co in WC (in the tables, referred to as CoW Compound) at a proportion undetectable by the X-ray diffraction measurement.

From X-ray diffraction patterns obtained by the X-ray diffraction measurement, the X-ray diffraction peak intensity (I_{WC}) on the (101) plane of WC and the X-ray diffraction peak intensity (I_{WB2}) on the (004) plane of WB₂ in the binder phase were determined, and the ratio of I_{WB2} to the total of I_{WC} and I_{WB2} was also calculated (in the tables, referred to as I_{WB2}/(I_{WC} + I_{WB2})). The X-ray diffraction peak of each crystal plane was referred to ICDD card described below. These results are shown in Table 6 and Table 7.
WC: No. 00-051-0939
WB₂: No. 01-089-3928

**[Table 6]**

| Sample No. | Cubic Boron Nitride Sintered Body | | | | | | | | | | | | |
|---|---|---|---|---|---|---|---|---|---|---|---|---|---|
| | cBN | Binder Phase | | | | | | | | | | | |
| | Content Ratio (Area%) | Content Ratio (Area%) | Ti Compound Phase | | Al Compound Phase | | W Compound Phase | | | | | Other Compounds | |
| | | | Composition | Content Ratio (Area%) | Composition | Content Ratio (Area%) | Composition | Content Ratio X1(Area%) | Content Ratio X2(Area%) | Relationship between X1 and X2 | Ratio X2/X1 | Composition | Content Ratio (Area%) |
| Invention Sample 1 | 30.0 | 70.0 | TiC, TiB₂ | 81.4 | Al₂O₃ | 8.6 | WC, CoW Compound | 10.0 | 15.0 | X1 < X2 | 1.50 | - | - |
| Invention Sample 2 | 58.0 | 42.0 | TiC, TiB₂ | 80.9 | Al₂O₃ | 12.9 | WC, WB₂, CoW Compound | 6.2 | 9.3 | X1 < X2 | 1.50 | - | - |
| Invention Sample 3 | 50.0 | 50.0 | TiC, TiB₂ | 82.0 | Al₂O₃ | 10.0 | WC, CoW Compound | 8.0 | 12.0 | X1 < X2 | 1.50 | - | - |
| Invention Sample 4 | 40.0 | 60.0 | TiC, TiB₂ | 81.7 | Al₂O₃ | 8.3 | WC, CoW Compound | 10.0 | 15.0 | X1 < X2 | 1.50 | - | - |
| Invention Sample 5 | 20.0 | 80.0 | TiC, TiB₂ | 81.3 | Al₂O₃ | 6.2 | WC, CoW Compound | 12.5 | 18.5 | X1 < X2 | 1.48 | - | - |
| Invention Sample 6 | 15.0 | 85.0 | TiC, TiB₂ | 82.4 | Al₂O₃ | 5.6 | WC, CoW Compound | 12.0 | 18.0 | X1 < X2 | 1.50 | - | - |
| Invention Sample 7 | 10.0 | 90.0 | TiC, TiB₂ | 82.2 | Al₂O₃ | 5.8 | WC, CoW Compound | 12.0 | 18.0 | X1 < X2 | 1.50 | - | - |
| Invention Sample 8 | 30.0 | 70.0 | TiC, TiB₂ | 87.9 | Al₂O₃ | 7.1 | WC, CoW Compound | 5.0 | 8.0 | X1 < X2 | 160 | - | - |
| Invention Sample 9 | 30.0 | 70.0 | TiC, TiB₂ | 72.1 | Al₂O₃ | 6.9 | WC, CoW Compound | 21.0 | 32.0 | X1 < X2 | 1.52 | - | - |
| Invention Sample 10 | 30.0 | 70.0 | TiC, TiB₂ | 67.1 | Al₂O₃ | 6.9 | WC, WB₂, CoW Compound | 26.0 | 39.0 | X1 < X2 | 1.50 | - | - |
| Invention Sample 11 | 30.0 | 70.0 | TiC, TiB₂ | 62.9 | Al₂O₃ | 7.1 | WC, WB₂, CoW Compound | 30.0 | 42.0 | X1 < X2 | 1.40 | - | - |
| Invention Sample 12 | 30.0 | 70.0 | TiC, TiB₂ | 72.1 | Al₂O₃, AIN | 20.0 | WC, CoW Compound | 7.9 | 12.0 | X1 < X2 | 1.52 | - | - |
| Invention Sample 13 | 30.0 | 70.0 | TiC, TiB₂ | 72.1 | Al₂O₃ | 15.9 | WC, CoW Compound | 12.0 | 18.0 | X1 < X2 | 1.50 | - | - |
| Invention Sample 14 | 30.0 | 70.0 | TiC, TiB₂ | 72.1 | Al₂O₃ | 2.2 | WC, WB₂, CoW Compound | 25.7 | 39.0 | X1 < X2 | 1.52 | - | - |
| Invention Sample 15 | 30.0 | 70.0 | TiC, TiB₂ | 69.3 | Al₂O₃ | 3.0 | WC, WB₂, CoW Compound | 27.7 | 36.0 | X1 < X2 | 1.30 | - | - |
| Invention Sample 16 | 30.0 | 70.0 | TiC, TiB₂ | 75.0 | Al₂O₃ | 3.0 | WC, CoW Compound | 22.0 | 33.0 | X1 < X2 | 1.50 | - | - |
| Invention Sample 17 | 30.0 | 70.0 | TiC, TiB₂ | 80.7 | Al₂O₃ | 3.1 | WC, CoW Compound | 16.2 | 24.5 | X1 < X2 | 1.51 | - | - |
| Invention Sample 18 | 30.0 | 70.0 | TiC, TiB₂ | 77.9 | Al₂O₃ | 16.0 | WC, CoW Compound | 6.1 | 10.5 | X1 < X2 | 1.72 | - | - |
| Invention Sample 19 | 30.0 | 70.0 | TiC, TiB₂ | 82.1 | Al₂O₃ | 15.7 | WC, CoW Compound | 2.2 | 4.5 | X1 < X2 | 2.05 | - | - |
| Invention Sample 20 | 30.0 | 70.0 | TiC, TiB₂ | 72.1 | Al₂O₃ | 10.0 | WC, WB₂, CoW Compound | 17.9 | 36.0 | X1 < X2 | 2.01 | - | - |
| Invention Sample 21 | 30.0 | 70.0 | TiC, TiB₂ | 72.1 | Al₂O₃ | 10.0 | WC, WB₂, CoW Compound | 17.9 | 32.0 | X1 < X2 | 1.79 | - | - |
| Invention Sample 22 | 30.0 | 70.0 | TiC, TiB₂ | 72.1 | Al₂O₃ | 10.0 | WC, CoW Compound | 17.9 | 24.0 | X1 < X2 | 1.34 | - | - |
| Invention Sample 23 | 30.0 | 70.0 | TiC, TiB₂ | 72.1 | Al₂O₃ | 10.0 | WC, CoW Compound | 17.9 | 22.0 | X1 < X2 | 1.23 | - | - |
| Invention Sample 24 | 30.0 | 70.0 | TiC, TiB₂ | 82.1 | Al₂O₃ | 7.9 | WC, CoW Compound | 10.0 | 19.0 | X1 < X2 | 1.90 | - | - |
| Invention Sample 25 | 30.0 | 70.0 | TiC, TiB₂ | 82.1 | Al₂O₃ | 7.9 | WC, CoW Compound | 10.0 | 18.0 | X1 < X2 | 1.80 | - | - |
| Invention Sample 26 | 30.0 | 70.0 | TiC, TiB₂ | 82.1 | Al₂O₃ | 7.9 | WC, CoW Compound | 10.0 | 12.0 | X1 < X2 | 120 | - | - |
| Invention Sample 27 | 30.0 | 70.0 | TiC, TiB₂ | 82.1 | Al₂O₃ | 7.9 | WC, CoW Compound | 10.0 | 110 | X1 < X2 | 1.10 | - | - |
| Invention Sample 28 | 30.0 | 70.0 | TiC, TiB₂ | 82.1 | Al₂O₃ | 7.9 | WC, Co₃W₃C | 10.0 | 15.0 | X1 < X2 | 1.50 | - | - |
| Invention Sample 29 | 30.0 | 70.0 | TiC, TiB₂ | 82.1 | Al₂O₃ | 7.9 | WC, CoW Compound | 10.0 | 15.0 | X1 < X2 | 1.50 | - | - |
| Invention Sample 30 | 30.0 | 70.0 | TiC, TiB₂ | 82.1 | Al₂O₃ | 7.9 | WC, CoW Compound | 10.0 | 15.0 | X1 < X2 | 1.50 | - | - |
| Invention Sample 31 | 30.0 | 70.0 | TiC, TiB₂ | 82.1 | Al₂O₃ | 7.9 | WC, CoW Compound | 10.0 | 15.0 | X1 < X2 | 1.50 | - | - |
| Invention Sample 32 | 30.0 | 70.0 | TiC, TiB₂ | 82.1 | Al₂O₃ | 7.9 | WC, CoW Compound | 10.0 | 15.0 | X1 < X2 | 1.50 | - | - |
| Invention Sample 33 | 30.0 | 70.0 | TiC, TiB₂ | 82.1 | Al₂O₃ | 7.9 | WC | 10.0 | 15.0 | X1 < X2 | 1.50 | - | - |
| Invention Sample 34 | 30.0 | 70.0 | TiN, TiB₂ | 82.1 | Al₂O₃ | 7.9 | WC, CoW Compound | 10.0 | 15.0 | X1 < X2 | 1.50 | - | - |
| Invention Sample 35 | 30.0 | 70.0 | TiCN, TiB₂ | 82.1 | Al₂O₃ | 7.9 | WC, CoW Compound | 10.0 | 15.0 | X1 < X2 | 1.50 | - | - |
| Invention Sample 36 | 30.0 | 70.0 | TiC, TiB₂ | 72.1 | Al₂O₃ | 8.7 | WC, CoW Compound | 11.1 | 16.6 | X1 < X2 | 1.50 | CrN | 8.1 |
| Invention Sample 31 | 30.0 | 70.0 | TiC, TiB₂ | 72.1 | Al₂O₃ | 8.7 | WC, CoW Compound | 11.1 | 16.6 | X1 < X2 | 1.50 | VC | 8.1 |
| Invention Sample 38 | 30.0 | 70.0 | TiC, TiB₂ | 72.1 | Al₂O₃ | 8.7 | WC, CoW Compound | 11.1 | 16.6 | X1 < X2 | 1.50 | NbN | 8.1 |
| Invention Sample 39 | 30.0 | 70.0 | TiC, TiB₂ | 72.1 | Al₂O₃ | 8.7 | WC, CoW Compound | 11.1 | 16.6 | X1 < X2 | 1.50 | Mo₂C | 8.1 |
| Comparative Sample 1 | 70.0 | 30.0 | TiC, TiB₂ | 81.7 | Al₂O₃ | 16.3 | WC, WB₂, CoW Compound | 2.0 | 3.0 | X1 < X2 | 1.50 | - | - |
| Comparative Sample 2 | 5.0 | 95.0 | TiC, TiB₂ | 82.0 | Al₂O₃ | 5.0 | WC, CoW Compound | 13.0 | 20.0 | X1 < X2 | 1.54 | - | - |
| Comparative Sample 3 | 30.0 | 70.0 | TiC, TiB₂ | 93.0 | Al₂O₃ | 3.0 | WC, CoW Compound | 4.0 | 6.0 | X1 < X2 | 1.50 | - | - |
| Comparative Sample 4 | 30.0 | 70.0 | TiC | 56.0 | Al₂O₃ | 7.0 | WC, WB₂, CoW Compound | 37.0 | 48.0 | X1 < X2 | 1.30 | - | - |
| Comparative Sample 5 | 30.0 | 70.0 | TiC, TiB₂ | 72.0 | Al₂O₃, AIN | 24.0 | WC, CoW Compound | 4.0 | 6.0 | X1 < X2 | 1.50 | - | - |
| Comparative Sample 6 | 30.0 | 70.0 | TiC, TiB₂ | 72.0 | - | 0.0 | WC, WB₂, CoW Compound | 28.0 | 42.0 | X1 < X2 | 1.50 | - | - |
| Comparative Sample 7 | 30.0 | 70.0 | TiC, TiB₂ | 65.0 | Al₂O₃ | 3.0 | WC, WB₂, CoW Compound | 32.0 | 38.0 | X1 < X2 | 1.19 | - | - |
| Comparative Sample 8 | 30.0 | 70.0 | TiC, TiB₂ | 84.0 | Al₂O₃ | 16.0 | - | - | - | - | - | - | - |
| Comparative Sample 9 | 30.0 | 70.0 | TiC, TiB₂ | 72.1 | Al₂O₃ | 10.0 | WC, WB₂, CoW Compound | 17.9 | 45.0 | X1 < X2 | 2.51 | - | - |
| Comparative Sample 10 | 30.0 | 70.0 | TiC, TiB₂ | 72.1 | Al₂O₃ | 10.0 | WC, CoW Compound | 17.9 | 17.9 | X1 = X2 | 1.00 | - | - |
| Comparative Sample 11 | 30.0 | 70.0 | TiC, TiB₂ | 82.1 | Al₂O₃ | 7.9 | WC, CoW Compound | 10.0 | 9.0 | X1 >X2 | 0.90 | - | - |
| Comparative Sample 12 | 30.0 | 70.0 | TiC, TiB₂ | 82.1 | Al₂O₃ | 7.9 | Co₃W₃C | 10.0 | 15.0 | X1 < X2 | 1.50 | - | - |

**[Table 7]**

| Sample No. | Cubic Boron Nitride Sintered Body | | | Sample No. | Cubic Boron Nitride Sintered Body | | |
|---|---|---|---|---|---|---|---|
| | X-Ray Diffraction Intensity Ratio | Atomic Ratio Co/(W+Co) | Average Grain Size Compound (µm) | | X-Ray Diffraction Intensity Ratio | Atomic Ratio Co/(W+Co) | Average Grain Size Compound (µm) |
| | I_{WB2}/(I_{WC} + I_{WB2}) | | | | I_{WB2}/(I_{WC} + I_{WB2}) | | |
| Invention Sample 1 | 0.00 | 0.30 | 1.5 | Comparative Sample 1 | 0.03 | 0.27 | 1.5 |
| Invention Sample 2 | 0.01 | 0.31 | 1.5 | Comparative Sample 2 | 0.00 | 0.29 | 1.5 |
| Invention Sample 3 | 0.00 | 0.32 | 1.5 | Comparative Sample 3 | 0.00 | 0.29 | 1.5 |
| Invention Sample 4 | 0.00 | 0.30 | 1.5 | Comparative Sample 4 | 0.06 | 0.30 | 1.5 |
| Invention Sample 5 | 0.00 | 0.32 | 1.5 | Comparative Sample 5 | 0.00 | 0.29 | 1.5 |
| Invention Sample 6 | 0.00 | 0.30 | 1.5 | Comparative Sample 6 | 0.05 | 0.30 | 1.5 |
| Invention Sample 7 | 0.00 | 0.30 | 1.5 | Comparative Sample 7 | 0.03 | 0.30 | 1.5 |
| Invention Sample 8 | 0.00 | 0.32 | 1.5 | Comparative Sample 8 | - | 0.00 | - |
| Invention Sample 9 | 0.00 | 0.30 | 1.5 | Comparative Sample 9 | 0.05 | 0.30 | 0.3 |
| Invention Sample 10 | 0.01 | 0.38 | 1.5 | Comparative Sample 10 | 0.00 | 0.30 | 4.0 |
| Invention Sample 11 | 0.03 | 0.30 | 1.5 | Comparative Sample 11 | 0.00 | 0.30 | 1.5 |
| Invention Sample 12 | 0.00 | 0.29 | 1.5 | Comparative Sample 12 | - | 0.60 | 1.5 |
| Invention Sample 13 | 0.00 | 0.31 | 1.5 | | | | |
| Invention Sample 14 | 0.03 | 0.30 | 1.5 | | | | |
| Invention Sample 15 | 0.02 | 0.29 | 1.5 | | | | |
| Invention Sample 16 | 0.00 | 0.30 | 1.5 | | | | |
| Invention Sample 17 | 0.00 | 0.30 | 1.5 | | | | |
| Invention Sample 18 | 0.00 | 0.30 | 1.5 | | | | |
| Invention Sample 19 | 0.00 | 0.32 | 1.5 | | | | |
| Invention Sample 20 | 0.02 | 0.30 | 0.5 | | | | |
| Invention Sample 21 | 0.01 | 0.30 | 1.0 | | | | |
| Invention Sample 22 | 0.00 | 0.30 | 2.0 | | | | |
| Invention Sample 23 | 0.00 | 0.30 | 3.0 | | | | |
| Invention Sample 24 | 0.00 | 0.30 | 1.5 | | | | |
| Invention Sample 25 | 0.00 | 0.30 | 1.5 | | | | |
| Invention Sample 26 | 0.00 | 0.30 | 1.5 | | | | |
| Invention Sample 27 | 0.00 | 0.30 | 1.5 | | | | |
| Invention Sample 28 | 0.00 | 0.50 | 1.5 | | | | |
| Invention Sample 29 | 0.00 | 0.43 | 1.5 | | | | |
| Invention Sample 30 | 0.00 | 0.20 | 1.5 | | | | |
| Invention Sample 31 | 0.00 | 0.10 | 1.5 | | | | |
| Invention Sample 32 | 0.00 | 0.05 | 1.5 | | | | |
| Invention Sample 33 | 0.00 | 0.00 | 1.5 | | | | |
| Invention Sample 34 | 0.00 | 0.30 | 1.5 | | | | |
| Invention Sample 35 | 0.00 | 0.30 | 1.5 | | | | |
| Invention Sample 36 | 0.00 | 0.30 | 1.5 | | | | |
| Invention Sample 37 | 0.00 | 0.30 | 1.5 | | | | |
| Invention Sample 38 | 0.00 | 0.30 | 1.5 | | | | |
| Invention Sample 39 | 0.00 | 0.30 | 1.5 | | | | |

### [Preparation of Cutting Tool]

Each of the obtained cBN sintered bodies was cut out so as to correspond to the insert-shaped tool shape defined in the ISO standard CNGA 120408 using a wire electric discharge machine. The cut-out cBN sintered body was joined to a cemented carbide base metal via brazing. The brazed tool was honing-processed to obtain a cutting tool.

By using the obtained samples, the following cutting test was performed for evaluation.

### [Cutting Test]

Work material: SCM415H carburized and hardened steel (HRC60),
Work material shape: Round bar,
Machining method: External turning
Cutting speed: 200 m/min,
Feed: 0.15 mm/rev,
Depth of cut: 0.12 mm,
Coolant: Used (water-soluble coolant)

Evaluation items: The tool life was defined as a machining time when the width of the flank wear of the tool reached 0.10 mm, or when fracture occurred, and the machining time to the end of the tool life was measured. The damage morphology of a sample in which the width of the flank wear of the tool reached 0.10 mm to come to the end of the tool life was defined as "normal wear", and the damage morphology of a sample that came to the end of the tool life due to fracture was defined as "fracture".

The results of the test are shown in Table 8.

**[Table 8]**

| Sample No. | Cutting Test | | Sample No. | Cutting Test | |
|---|---|---|---|---|---|
| | Machining Time (min) | Damage Morphology | | Machining Time (min) | Damage Morphology |
| Invention Sample 1 | 35 | Normal Wear | Comparative Sample 1 | 17 | Normal Wear |
| Invention Sample 2 | 25 | Normal Wear | Comparative Sample 2 | 13 | Fracture |
| Invention Sample 3 | 28 | Normal Wear | Comparative Sample 3 | 12 | Fracture |
| Invention Sample 4 | 31 | Normal Wear | Comparative Sample 4 | 12 | Fracture |
| Invention Sample 5 | 34 | Normal Wear | Comparative Sample 5 | 9 | Fracture |
| Invention Sample 6 | 32 | Normal Wear | Comparative Sample 6 | 7 | Fracture |
| Invention Sample 7 | 27 | Normal Wear | Comparative Sample 7 | 17 | Normal Wear |
| Invention Sample 8 | 30 | Normal Wear | Comparative Sample 8 | 8 | Fracture |
| Invention Sample 9 | 33 | Normal Wear | Comparative Sample 9 | 9 | Fracture |
| Invention Sample 10 | 28 | Normal Wear | Comparative Sample 10 | 15 | Fracture |
| Invention Sample 11 | 24 | Normal Wear | Comparative Sample 11 | 14 | Fracture |
| Invention Sample 12 | 22 | Normal Wear | Comparative Sample 12 | 10 | Fracture |
| Invention Sample 13 | 31 | Normal Wear | | | |
| Invention Sample 14 | 27 | Normal Wear | | | |
| Invention Sample 15 | 24 | Normal Wear | | | |
| Invention Sample 16 | 31 | Normal Wear | | | |
| Invention Sample 17 | 34 | Normal Wear | | | |
| Invention Sample 18 | 31 | Normal Wear | | | |
| Invention Sample 19 | 22 | Normal Wear | | | |
| Invention Sample 20 | 24 | Normal Wear | | | |
| Invention Sample 21 | 26 | Normal Wear | | | |
| Invention Sample 22 | 33 | Normal Wear | | | |
| Invention Sample 23 | 24 | Normal Wear | | | |
| Invention Sample 24 | 27 | Normal Wear | | | |
| Invention Sample 25 | 30 | Normal Wear | | | |
| Invention Sample 26 | 27 | Normal Wear | | | |
| Invention Sample 27 | 21 | Normal Wear | | | |
| Invention Sample 28 | 22 | Normal Wear | | | |
| Invention Sample 29 | 30 | Normal Wear | | | |
| Invention Sample 30 | 33 | Normal Wear | | | |
| Invention Sample 31 | 28 | Normal Wear | | | |
| Invention Sample 32 | 24 | Normal Wear | | | |
| Invention Sample 33 | 20 | Normal Wear | | | |
| Invention Sample 34 | 28 | Normal Wear | | | |
| Invention Sample 35 | 32 | Normal Wear | | | |
| Invention Sample 36 | 33 | Normal Wear | | | |
| Invention Sample 37 | 36 | Normal Wear | | | |
| Invention Sample 38 | 34 | Normal Wear | | | |
| Invention Sample 39 | 35 | Normal Wear | | | |

The results shown in Table 8 demonstrated that a cutting tool using the cBN sintered body of an invention sample had better wear resistance and fracture resistance than those of a cutting tool using the cBN sintered body of comparative sample and offered a long tool life.

### (Example 2)

Next, as shown in Table 9, each of the cubic boron nitride sintered bodies of invention sample 2, invention sample 7, invention sample 15, and invention sample 19 obtained in Example 1 was surface-treated by ion bombardment, followed by coating layer formation by the arc ion plating method. In the case of forming the first and second layers, these layers were formed in this order on the surface of the cubic boron nitride sintered body. In the composition of the first layer, the respective layers of the compounds (50 nm per layer) were formed alternately and repeatedly to attain the average thickness of the first layer, in invention sample 41, 47, 51, 55, and 59 containing two compounds. Their respective treatment conditions were as shown below. The composition and the average thickness of the coating layer were as shown in Table 9.

### [Conditions of Ion Bombardment]

Base material temperature: 500°C,
Pressure: Ar gas atmosphere of 2.7 Pa
Voltage: -400 V,
Current: 40 A,
Time: 30 minutes.

### [Coating Layer Formation Conditions]

Base material temperature: 500°C,
Pressure: Nitrogen (N₂) gas atmosphere of 3.0 Pa (nitride layer), or mixed gas atmosphere with nitrogen (N₂) gas and acetylene gas (C₂H₂) of 3.0 Pa (carbonitride layer),
Voltage: -60 V,
Current: 120 A.

**[Table 9]**

| Sample No. | Cubic Boron Nitride Sintered Body | Coating Laver | | | | |
|---|---|---|---|---|---|---|
| | | First Layer | | Second Layer | | Average Thickness of Whole (µm) |
| | | Composition | Average Thickness (µm) | Composition | Average Thickness (µm) | |
| Invention Sample 40 | Invention Sample 2 | TiCN | 1.0 | - | - | 1.0 |
| Invention Sample 41 | Invention Sample 2 | Ti_{0.50}Al_{0.50}N/Ti_{0.33}Al_{0.67}N | 0.5 | - | - | 0.5 |
| Invention Sample 42 | Invention Sample 2 | TiN | 0.2 | Ti_{0.50}Al_{0.50}N | 1.3 | 1.5 |
| Invention Sample 43 | Invention Sample 2 | Ti_{0.50}Al_{0.50}N | 0.2 | TiCN | 1.3 | 1.5 |
| Invention Sample 44 | Invention Sample 2 | TiCN | 5.0 | - | - | 5.0 |
| Invention Sample 45 | Invention Sample 2 | Ti_{0.50}Al_{0.50}N | 3.0 | - | - | 3.0 |
| Invention Sample 46 | Invention Sample 2 | TiN | 0.5 | TiCN | 4.5 | 5.0 |
| Invention Sample 47 | Invention Sample 2 | Ti_{0.50}Al_{0.50}N/Ti_{0.33}Al_{0.67}N | 4.5 | Ti_{0.90}Si_{0.10}N | 0.5 | 5.0 |
| Invention Sample 48 | Invention Sample 7 | TiCN | 1.0 | - | - | 1.0 |
| Invention Sample 49 | Invention Sample 7 | Ti_{0.50}Al_{0.50}N | 6.0 | - | - | 6.0 |
| Invention Sample 50 | Invention Sample 7 | TiN | 0.5 | TiCN | 1.0 | 1.5 |
| Invention Sample 51 | Invention Sample 7 | Ti_{0.50}Al_{0.50}N/Ti_{0.33}Al_{0.67}N | 6.0 | CrN | 0.5 | 6.5 |
| Invention Sample 52 | Invention Sample 15 | TiCN | 1.0 | - | - | 1.0 |
| Invention Sample 53 | Invention Sample 15 | Ti_{0.50}Al_{0.50}N | 6.0 | - | - | 6.0 |
| Invention Sample 54 | Invention Sample 15 | TiN | 0.5 | TiCN | 1.0 | 1.5 |
| Invention Sample 55 | Invention Sample 15 | Ti_{0.50}Al_{0.50}N/Ti_{0.33}Al_{0.67}N | 6.0 | NbN | 0.5 | 6.5 |
| Invention Sample 56 | Invention Sample 19 | TiCN | 1.0 | - | - | 1.0 |
| Invention Sample 57 | Invention Sample 19 | Ti_{0.50}Al_{0.50}N | 6.0 | - | - | 6.0 |
| Invention Sample 58 | Invention Sample 19 | TiN | 0.5 | TiCN | 1.0 | 1.5 |
| Invention Sample 59 | Invention Sample 19 | Ti_{0.50}Al_{0.50}N/Ti_{0.33}Al_{0.67}N | 6.0 | Ti_{0.50}Al_{0.50}N | 0.5 | 6.5 |

By using the obtained coated cubic boron nitride sintered bodies, the same cutting test as in Example 1 was performed for evaluation of invention samples. The results are shown in Table 10.

**[Table 10]**

| Sample No. | Cutting Test | |
|---|---|---|
| | Machining Time (min) | Damage Morphology |
| Invention Sample 40 | 28 | Normal Wear |
| Invention Sample 41 | 26 | Normal Wear |
| Invention Sample 42 | 27 | Normal Wear |
| Invention Sample 43 | 29 | Normal Wear |
| Invention Sample 44 | 32 | Normal Wear |
| Invention Sample 45 | 30 | Normal Wear |
| Invention Sample 46 | 33 | Normal Wear |
| Invention Sample 47 | 34 | Normal Wear |
| Invention Sample 48 | 29 | Normal Wear |
| Invention Sample 49 | 33 | Normal Wear |
| Invention Sample 50 | 31 | Normal Wear |
| Invention Sample 51 | 33 | Normal Wear |
| Invention Sample 52 | 28 | Normal Wear |
| Invention Sample 53 | 32 | Normal Wear |
| Invention Sample 54 | 28 | Normal Wear |
| Invention Sample 55 | 32 | Normal Wear |
| Invention Sample 56 | 26 | Normal Wear |
| Invention Sample 57 | 30 | Normal Wear |
| Invention Sample 58 | 25 | Normal Wear |
| Invention Sample 59 | 32 | Normal Wear |

The results shown in Table 10 demonstrated that a coated cBN sintered body with a coating layer formed on the surface (invention samples 40 to 59) had further better wear resistance and fracture resistance than those of a cBN sintered body with no coating layer formed (invention samples 2, 7, 15, and 19), and offered a long tool life.

### Industrial Applicability

The cubic boron nitride sintered body and the coated cubic boron nitride sintered body of the present invention can extend the tool life compared to conventional ones due to excellent wear resistance and excellent fracture resistance, and are highly industrially applicable in that point.

## Claims

1. A cubic boron nitride sintered body comprising cubic boron nitride and a binder phase, wherein
when a cross-sectional structure of the cubic boron nitride sintered body is observed, a content ratio of the cubic boron nitride is 10.0 area% or more and 60.0 area% or less, and a content ratio of the binder phase is 40.0 area% or more and 90.0 area% or less, based on 100 area% in total of the cubic boron nitride sintered body,
the binder phase comprises a Ti compound phase, an Al compound phase, and a W compound phase,
the Ti compound phase comprises a compound of Ti and at least one element selected from the group consisting of C, N, O, and B,
the Al compound phase comprises a compound of Al and at least one element selected from the group consisting of C, N, O, and B,
the W compound phase comprises WC,
an average grain size of the W compound phase is 0.5 µm or more and 3.0 µm or less,
in the cross-sectional structure, a content ratio of the Ti compound phase is 60.0 area% or more and 90.0 area% or less, a content ratio of the Al compound phase is more than 0.0 area% and 20.0 area% or less, and a content ratio X1 of the W compound phase is 2.0 area% or more and 30.0 area% or less, based on 100 area% in total of the binder phase, and
in the cross-sectional structure, a content ratio X2 of the W compound phase based on 100 area% in total of the binder phase is larger than the content ratio X1 in a range from an interface between the cubic boron nitride and the binder phase to a distance of 300 nm toward the binder phase side.

2. The cubic boron nitride sintered body according to claim 1, wherein
the W compound phase further comprises at least one of a compound (except for WC) of W and at least one element selected from the group consisting of C, N, O, and B, and a compound of W and Co and at least one element selected from the group consisting of C, N, O, and B.

3. The cubic boron nitride sintered body according to claim 1 or 2, wherein
a ratio of the content ratio X2 to the content ratio X1 is 1.10 or more and 2.10 or less.

4. The cubic boron nitride sintered body according to any one of claim 1 to 3, wherein
the content ratio X2 is 3.0 area% or more and 45.0 area% or less.

5. The cubic boron nitride sintered body according to any one of claim 1 to 4, wherein
when an X-ray diffraction peak intensity on a (101) plane of WC in the binder phase is defined as I_{WC} and an X-ray diffraction peak intensity on a (004) plane of WB₂ is defined as I_{WB2}, a ratio of I_{WB2} to a total of I_{WC} and I_{WB2} is 0.00 or more and 0.03 or less.

6. The cubic boron nitride sintered body according to any one of claim 1 to 5, wherein
the W compound phase further comprises a compound of W and Co and at least one element selected from the group consisting of C, N, O, and B, and a content ratio (atomic ratio) of the Co element to a total content ratio of the W element and the Co element is 0.05 or more and 0.50 or less.

7. A coated cubic boron nitride sintered body comprising the cubic boron nitride sintered body according to any one of claims 1 to 6 and a coating layer formed on a surface of the cubic boron nitride sintered body, wherein
the coating layer is a single layer or a lamination of two or more layers, comprising at least one element selected from the group consisting of Ti, Zr, Hf, V, Nb, Ta, Cr, Mo, W, Al, and Si, and at least one element selected from the group consisting of C, N, O, and B, and
an average thickness of a whole of the coating layer is 0.5 µm or more and 8.0 µm or less.

8. A tool comprising the cubic boron nitride sintered body according to any one of claims 1 to 6.

9. A tool comprising the coated cubic boron nitride sintered body according to claim 7.
